Europäisches Patentamt

European Patent Office

Office européen des brevets

(11) Veröffentlichungsnummer: **0 327 816 B1**

(19)

(12) **EUROPÄISCHE PATENTSCHRIFT**

(45) Veröffentlichungstag der Patentschrift: **08.09.93**

(21) Anmeldenummer: **89100409.5**

(22) Anmeldetag: **11.01.89**

(51) Int. Cl.⁵: **H01B 1/16**, H01L 21/48, H01C 17/28, H01L 23/498

---

(54) **Nicht-oxidierende Kupfer-Dickfilmleiter.**

---

(30) Priorität: **11.02.88 US 154729**

(43) Veröffentlichungstag der Anmeldung:
**16.08.89 Patentblatt 89/33**

(45) Bekanntmachung des Hinweises auf die Patenterteilung:
**08.09.93 Patentblatt 93/36**

(84) Benannte Vertragsstaaten:
**DE FR GB IT**

(56) Entgegenhaltungen:
**EP-A- 0 028 819        EP-A- 0 135 174
EP-A- 0 200 950        US-A- 4 070 518
US-A- 4 072 771        US-B- 553 421**

(73) Patentinhaber: **W.C. Heraeus GmbH
Heraeusstrasse 12 - 14 Postfach 1553
D-63405 Hanau(DE)**

(72) Erfinder: **Steinberg, Jerry, Dr.
1916 Kynwyd Road
Wilmington, DE 19428(US)**

(74) Vertreter: **Heinen, Gerhard, Dr.
Heraeus Holding GmbH Zentralbereich Patente und Lizenzen Heraeusstrasse 12-14
D-63450 Hanau (DE)**

## Beschreibung

Diese Erfindung bezieht sich auf einen unter Stickstoff einbrennbaren nicht-oxidierenden, leicht lötbaren Kupfer-Dickfilmleiter.

Die Hybrid-Mikroelektronik-Industrie forciert sehr die Entwicklung von Metall-Leitpasten. Im Gegensatz zu Edelmetallen vermindert Kupfer nicht nur die Kosten, sondern zeigt auch bessere elektrische Eigenschaften als die meisten Edelmetall-Gegenstücke. Die Annahme von Kupfer erfolgte aus folgenden Gründen nur zögernd: Verfügbarkeit von kompatiblen Widerständen, Bedarf von neuen Kapital-Investitionen für Ausrüstung sowie Verarbeitungsschwierigkeiten. Diese Erfindung behandelt den letzten dieser Punkte.

Die US-PS 4 514 321 und US-PS 4 540 604 behandeln Kupferpasten-Zusammensetzungen, die Reduktionsmittel für Kupferoxide enthalten.

Die US-PS 4 072 771 bezieht sich auf eine Leiterzusammensetzung, die auf voroxidierten Kupferpartikeln beruht.

Die US-PS 4 323 483 bezieht sich auf glasfreie Kupferleiter-Zusammensetzungen, die für das Herstellen von Mikrowellenleitern nützlich sind.

Die US-PS 3 988 647 offenbart eine Kupferleiter-Zusammensetzung, die oxidfreie Kupferpartikel verwendet.

Die US-PS 4 070 518 behandelt einen Kupferleiter, der eine Fritte enthält, die blei und wismutfrei ist.

Die US-PS 4 172 919 bezieht sich auf Kupferleiter mit hoch wismuthaltigen Gläsern.

Die JP-OS 62-2405 offenbart eine Dickfilm-Kupferleiter-Zusammensetzung, die Kupferpulver, Manganoxid, Kupferoxid und Glas enthält. Die US-PS 3 929 674 behandelt Edelmetall (Pt, Pd, Au, Ag) Dickfilmleiter-Zusammensetzungen mit verbesserten Eigenschaften, wenn diese Aluminiumborid und/oder andere Boride oder Silicide enthalten.

Die US-PS 4 090 009 betrifft elektrische Leiter, hergestellt aus Pd/Ag und einem anorganischen Bindemittel. Das Bindemittel muß frei von Wismutoxid sein, um nachhaltige Veränderungen an Leiter/Widerstand-Grenzflächen zu vermindern.

Die US-PS 4 001 146 bezieht sich auf elektrische Leiter aus a) Metallpulver aus Silber oder einer Mischung aus Silber und Pt, Pd, Au oder einer Legierung aus Kupfer mit Pt, Pd, Au und/oder Ag und b) einem glasfreien anorganischen Bindemittel, das Wismutoxid und Oxide von Kupfer und/oder Blei enthält.

Die US-PS 3 881 914 beschreibt die Verwendung einer phosphathaltigen Säure als Reduktionsmittel für Kupferoxid.

Bisher gab es noch keinen Kupferleiter, der gleichzeitig die Eigenschaften von guter Haftfestigkeit, guter Lötbarkeit sowie guter Leitfähigkeit selbst nach mehrfachem Einbrennen mit der zusätzlichen Eigenschaft, nicht-oxidierend zu sein, aufwies.

Während der weiteren Behandlung eines gebrannten Leiters verändert sich normalerweise seine Oberfläche, bedingt durch Umweltbedingungen, d. h. Oxidieren. Das kann nachfolgende Verarbeitungsschwierigkeiten beim Löten und letztlich bei der Bauteil-Bestückung mit sich bringen.

Bisher wurden teure Edelmetalle anstelle von Kupfer verwendet, da diese Metalle nicht schon nach kurzer Zeit oxidieren.

Bei der alternativen Verwendung von Kupfer mußte man dieses sehr schnell verarbeiten.

Ein Ziel dieser Erfindung ist, einen Kupfer-Dickfilmleiter zur Verfügung zu stellen, der eine gute Haftfestigkeit besitzt, lötbar ist und keine verminderte Lötbarkeit nach langen Lagerzeiten bei Raumtemperatur, höherer Temperatur von ca. 50°C oder kurzzeitigem Einwirken von Feuchtigkeit zeigt.

Ein weiteres Ziel dieser Erfindung ist, einen Kupfer-Dickfilmleiter zu erhalten, der das vollständige Versintern der Kupferpartikel erlaubt und somit die Anzahl der Korngrenzen minimiert, was wiederum die unerwünschte Oxidation des Kupfers verhindert.

Die oben genannten Absichten und Ziele und andere Vorteile werden durch diese Erfindung erfüllt, die sich auf einen nicht-oxidierenden Kupfer-Dickfilmleiter bezieht, der Kupfer enthält, das wiederum metallisches Kupferund Kupferoxidpulver umfaßt. Zusätzlich zu dem Kupfer wird eine Mangan-Bor-Verbindung, eine anorganische phosphathaltige Säure und ein organisches Trägermittel angewandt, in dem die Menge der Mangan-Bor-Verbindung 0,5 bis 1,5 Gewichts-%, bezogen auf das Gesamtgewicht des Leiters, und die Menge des Phosphates 50 bis 300 ppm, bezogen auf das Gewicht des metallischen Kupferpulvers, beträgt.

Die vorliegende Erfindung dient dazu, die bisherigen Schwierigkeiten des Standes der Technik zu lösen, indem die gebrannte Kupferschicht eine reine metallische Oberfläche aufweist, die nicht anfällig für Oxidation ist und lötbar ist nach längerer Lagerung bei Raumtemperatur oder Alterung während 72 Stunden bei 50°C oder 24 Stunden bei 85% relativer Luftfeuchtigkeit und 85°C. Die Zusammensetzungen weisen ebenfalls eine gute Haftfestigkeit nach längerer Alterung (150°C) auf Aluminiumoxid-Substraten auf.

EP 0 327 816 B1

Materialien, die diese Eigenschaften der gebrannten Kupferschicht verleihen, sind Manganborid ($MnB_2$) oder Manganborat und eine anorganische Phosphor- oder Phosphorige Säure, wie die unterphosphorige Säure ($H[H_2PO_2]$) oder die Orthophosphorsäure ($H_3PO_4$).

Die Dickfilm-Paste dieser Erfindung ist im Anspruch 1 definiert.

Sie enthält gegebenenfalls andere Zusätze, wie Glasfritten, Wismutoxid, Bleidioxid, Antimonoxid oder Edelmetall-Pulver.

Die physikalischen Eigenschaften des Kupferpulvers sind wichtig für die gebrannte Schicht, um die Eigenschaften, wie gute Haftfestigkeit, Lötbarkeit und hohe Leitfähigkeit, zu erhalten. Der Oxidgehalt des Kupferpulvers ist wichtig für ein richtiges Ausbrennen des organischen Trägermittels, wie in der US-PS 4 514 321 beschrieben.

Typische Partikelgrößen (Sedigraph) sind die folgenden:

90 % kleiner als 4 - 9,0 Mikrometer

50 % kleiner als 2 - 7,0 Mikrometer

10 % kleiner als 1 - 3,0 Mikrometer.

Die spezifische Oberfläche (BET MONOSORB) kann 0,50 bis 1,20 $m^2$/g betragen. BET MONOSORB ist eine Meßmethode zur Bestimmung der spezifischen Oberfläche eines Pulvers. Sie beinhaltet die Festlegung des Gasvolumens, das nötig ist, um das Pulver mit einer monomolekularen Schicht des adsorbierten Gases abzudecken; aus dem Molekül-Durchmesser wird die spezifische Oberfläche berechnet.

Die Klopfdichte kann 2,5 bis 4,2 g/$cm^3$ betragen.

Der Gehalt an Kupferoxid-Pulver kann von 4 bis 10 Gewichts-%, vorzugsweise von 5 bis 8 Gewichts-%, reichen, bezogen auf das Gesamtgewicht der Leiter-Zusammensetzung.

Vorzugsweise besitzt das metallische Kupferpulver eine monomolekulare Schicht einer anorganischen Phosphor- oder Phosphorigen äure. Vorzugsweise sind wenigstens 70 % des gesamten metallischen Kupferpulvers mit einer anorganischen Phosphor- oder Phosphorigsäure-Beschichtung versehen.

Die physikalischen Eigenschaften des Kupferoxid-Pulvers sind für gute Haftfestigkeit, Lötbarkeit sowie Trägermittelausbrand wichtig. Bei einer Brenntemperatur von 900°C kann Kupferoxid mit dem Aluminiumoxid-Substrat reagieren, um $CuAl_2O_4$ zu bilden. Auf diese Weise wird eine haftfeste Verbindung gebildet. Zu wenig Kupferoxid erzeugt ungenügende Haftfestigkeit, während zu viel Kupferoxid die Lötbarkeit herabsetzt.

Bevorzugt wird in dieser Erfindung Kupferoxid-Pulver in Form von Kupfer(II)-oxid, CuO. Diese Verbindung reduziert sich in einer Stickstoffatmosphäre bei einer Temperatur von ca. 700°C zu $Cu_2O$ gemäß der Reaktionsgleichung $CuO \rightarrow 1/2\ Cu_2O + 1/4\ O_2$. Der freigesetzte Sauerstoff unterstützt das Ausbrennen (Oxidieren) des organischen Trägermittels und führt dazu, daß die örtliche Atmosphäre weniger reduzierend wirkt. Das bedeutet, daß die Leiter weniger empfindlich auf Verarbeitungsbedingungen, wie z.B. vollgeladene Ofenbänder, reagieren.

Bevorzugte Partikelgrößen für Kupferoxid sind:

90 % kleiner als 3,0 - 8,0 Mikrometer

50 % kleiner als 1,5 - 4,0 Mikrometer

10 % kleiner als 1,0 - 2,5 Mikrometer.

Eine bevorzugte spezifische Oberfläche für Kupferoxid liegt im Bereich von 2 bis 6 $m^2$/g.

Die Mangan-Bor-Verbindungen, z.B. Manganborid oder Manganborat, in Kombination mit der anorganischen Phosphorsäure verleihen den gebrannten Schichten ihre nicht-oxidierende Oberfläche und Haftfestigkeit.

Die Menge der Mangan-Bor-Verbindung, wie sie in dieser Erfindung verwendet wird, beträgt 0,5 bis 1,5 Gewichts-% des Gesamtgewichtes der Leiterzusammensetzung, vorzugsweise beträgt sie 0,7 bis 1,2 Gewichts-% des Gesamtgewichtes der Leiterzusammensetzung.

Röntgenbeugungsanalysen haben gezeigt, daß $MnB_2$ das Kupferoxid beim Einbrand bei 900°C in Stickstoff-Atmosphäre reduziert. Basierend auf diesem Ergebnis, wurde folgender Reaktionsablauf unterstellt:

$$MnB_2 + 3\ CuO \rightarrow 3\ Cu + Mn + B_2O_3$$

Ohne an eine detaillierte Theorie der Funktionsweise gebunden zu sein, geht man davon aus, daß Mangan als Flüssigphasen-Sinterhilfsmittel fungiert, um die Verdichtung der Kupferschicht zu unterstützen. Gleichzeitig geht man davon aus, daß die Phosporsäure folgende Reaktion durchläuft:

$$2\ H(H_2PO_2) + Cu_2O \rightarrow 2\ Cu + P_2O_5 + 3\ H_2$$

3

oder

$$2\ H_3PO_4\ \text{-->}\ 3\ H_2O\ +\ P_2O_5$$

Es wird angenommen, daß $P_2O_5$ und $B_2O_3$, die beide gute Glasbildner sind, sich verbinden, um ein niedrigschmelzendes Glas zu bilden, das folgenden zwei wesentlichen Zwecken dient:

1. Es löst $Cu_2O$ auf, so daß die Kinetik der Bildung von $CuAl_2O_4$ beschleunigt wird.

2. Es wandert an die Oberfläche des Leiters und bildet eine Schutzschicht. Diese Schutzschicht verhindert die Oxidation der gebrannten Leiteroberfläche. Während des Lötprozesses kann man diese leicht auflösen und die reine Kupferoberfläche mit Lot benetzen.

Die bevorzugte spezifische Oberfläche für die Mangan-Bor-Verbindung beträgt 0,5 bis 3,0 m$^2$/g.

Jede Phosphor- oder phosphorige Säuren wird den gewünschten Effekt ergeben.

Phosphorige Säuren werden bevorzugt, da sie reduzierend auf Kupferoxid wirken, und wenn sie als Überzug auf Kupferpulver zugesetzt werden, werden sie es vor dem Oxidieren vor dem Brennen und bevor es in eine Dickfilmpaste eingearbeitet wird, bewahren.

Die folgenden Phosphorsäuren und phosphorigen Säuren können in dieser Erfindung verwendet werden:

| Phosphorsäuren | Phosphorige Säuren |
|---|---|
| Hypo $H_4P_2O_6$ . $2H_2O$ | Hypo $H(H_2PO_2)$ |
| Meta $HPO_3$ | Meta $HPO_2$ |
| Ortho $H_3PO_4$ | Ortho $H_2(HPO_3)$ |
| Difluoro $HPO_2F_2$ | Pyro $H_4P_2O_5$ |

Die bevorzugte Phosphat/Phosphit-Menge beträgt 50 bis 300 ppm und optimalerweise 70 und 150 ppm, bezogen auf das Gewicht des metallischen Kupferpulvers.

Andere anorganische Zusätze, die in dieser Erfindung eingesetzt werden können, sind alle zur Herstellung von Dickfilm-Leitern bekannten Zusätze, wie Silber, Glasfritten, Wismutoxid, Bleioxid. Die physikalischen Eigenschaften von solchen Zusätzen sind nicht kritisch.

Glasfritten, die in dieser Erfindunbg verwendet werden, sind die, die gewöhnlich in Dickfilmpasten benutzt werden. Sie gehören typischerweise der Blei-Bor-Silikat-Gruppe mit Modifikatoren, wie ZnO, $Bi_2O_3$, $Al_2O_3$, CdO, $TeO_2$, CuO, $Cu_2O$, $TiO_2$, $Na_2O$, CaO, SrO und BaO, an.

Andere Zusätze für die Anwendung in dieser Erfindung sind Oxide, die die Haftfestigkeit fördern, d. h. solche, die Verbindungen vom Spinelltyp mit den Aluminiumoxid-Substraten bilden, z. B. NiO, MgO, MnO, ZnO und CdO. Andere Zusätze, die in dieser Erfindung verwendet werden können, sind die, die als Glasflußmittel fungieren wie PbO und $Bi_2O_3$. Werkstoffe, die das Ausbrennen des organischen Trägermittels fördern, wie $PbO_2$ oder $BaO_2$, $Ba(NO_3)_2$ oder $Pb(NO_3)_2$, können in dieser Erfindung ebenfalls als Zusätze verwendet werden.

Ein passendes organisches Trägermittel für die Anwendung in dieser Erfindung wäre ein solches, das bei einer ziemlich niedrigen Temperatur (ca. 400 °C bis 500 °C) sich rückstandslos verflüchtigt. Jede inerte Flüssigkeit, die diese Anforderungen erfüllt, kann verwendet werden.

Verschiedene organische Flüssigkeiten mit oder ohne Verdickungs- und/oder Stabilisierungsmittel und/oder anderen Zusätzen können in der vorliegenden Erfindung verwendet werden.

Beispielhafte organische Flüssigkeiten, die in dieser Erfindung verwendet werden können, sind Alkohole, die 8 bis 15 Kohlenstoffatome haben, und Ester von Alkoholen. Beispiele solcher Alkohole sind Alkohol "Texanol" und Terpineol. Andere organische Flüssigkeiten, die in dieser Erfindung verwendet werden können, enthalten Terpene, wie Pineöl; Phthalate, wie Dibutyl-, Dioctyl-, Dimethyl- oder Diäthylphthalate, sind geeignete Stabilisierungsmittel. Der Hauptzweck des Trägermittels ist, während des Druckprozesses das Passieren der Paste durch das Sieb zu unterstutzen. Diese organischen Flüssigkeiten müssen einen Dampfdruck besitzen, der niedrig genug ist, um auf dem Sieb für ein paar Stunden bei minimaler Verdampfung, die zum Eindicken der Paste und somit zu schlechter Übertragung und anschließenden Druckproblemen führt, zu verbleiben. Die organischen Flüssigkeiten selbst oder in irgendeiner Kombination müssen das Harz auflösen oder gelieren. Das Harz sollte ein Acrylatharz und/oder Äthylcesllulose sein, obwohl jedes Harz, das gute Siebdruckeigenschaften aufweist, mit der geeigneten organischen Flüssigkeit in vorliegender Erfindung verwendet werden kann.

Die Erfindung wird nun anhand der folgenden Beispiele beschrieben. Beispiele A bis M sind in der Tabelle zusammengefaßt. Es folgt eine kurze Zusammenfassung der Beispiele.

Allgemeine Verfahren für die Beispiele

Die anorganischen Pulver, die in den Beispielen verwendet wurden, wurden in einem organischen Medium durch mechanisches Mischen zuerst mit einem Hobart-Planetenmischer, dann mit einem Drei-Walzenstuhl dispergiert. Der Grad der Dispersion wurde durch Verwendung eines Hegman-Grindometers festgelegt. Dieses Instrument besteht aus einer Furche in einem Stahl-Block, deren Tiefe zwischen 25 Mikrometer bis 0 Mikrometer variiert. Die Paste wird über die Furche verteilt. Eine Klinge, die über diese Furche gezogen wird, verursacht Riefen, die in der Paste erscheinen, wo die Agglomerat-Größe der Paste größer ist als die Tiefe der Furche. Typischerweise wird eine gut dispergierte Paste einen 50 %-Wert (definiert, wo die Furche halb mit Riefen bedeckt ist) von weniger als 12 Mikrometer ergeben.

Die dispergierte Paste wurde dann auf ein Aluminiumoxid-Substrat siebgedruckt. Nach dem Trocknen bei 110°C - 130°C während ca. 10 Minuten, um die Lösungsmittel zu entfernen, wurden die Teile auf das Band eines Durchlaufofens gelegt. Der Durchlaufofen hatte ein geregeltes Temperaturprofil, dessen Spitzentemperatur bei 900°C ± 10°C lag. Die gesamte Einbrennzeit betrug 40 bis 70 Minuten. Dieser Ofen enthielt eine nicht-oxidierende Atmosphäre (Stickstoff) mit 1 - 20 ppm Sauerstoff, um das Kupfer vor übermäßiger Oxidation zu schützen. Das Einbrennen wurde durchgeführt, um die betreffenden Pulver zu sintern oder zu verdichten und um chemische Reaktionen hervorzurufen, die die End-Eigenschaften, wie Haftfestigkeit, Lötbarkeit und Leitfähigkeit, beeinflussen. Nach dem Brennen wurden die Teile auf deren Eigenschaften getestet.

Zur Bestimmung der Haftfestigkeit wurden 20 gauge dicke verzinnte Drähte auf 80 x 80 mm großen Anschlußflächen durch 10 Sekunden langes Eintauchen in ein Lotbad aus 62 Sn/36 Pb/2 Ag oder 63 Sn/37 Pb befestigt. Die Temperatur des Lotbades betrug 220°C - 230°C. Als Flußmittel wurde "Alpha 611" ("Alpha 611" ist der Handelsname für Lot-Flußmittel), hergestellt von Alpha Metals Inc., Jersey City, New Jersey, USA) verwendet.

Die Drähte wurden dann in einem Winkel von 90°C zum Substrat so lange gezogen, bis sie sich vom Substrat lösten. Die Kraft, die man benötigte, um die Drähte zu lösen, nennt man Haftfestigkeit. Die Bestimmung der gealterten Haftfestigkeit wurde wie oben vorgenommen, jedoch nachdem die gelöteten Teile in einen Ofen bei 150°C während 100 Stunden gelagert worden waren.

Die Lötbarkeit wurde bestimmt, indem man die Teile in Lot tauchte, sie während 10 Sekunden auf der Oberfläche des geschmolzenen Lotes vorheizte und dann für 10 Sekunden in das Lot eintauchen ließ. Das Teil wurde herausgezogen, gereinigt und dann untersucht. Die Lötbarkeit wurde bestimmt durch den prozentualen Anteil der lotbedeckten Fläche, die man auf einer 80 x 80 mm-Anschlußfläche erhielt.

Die Oberfläche des gebrannten Kupfers wurde vor und nach der 48-stündigen Alterung bei 150°C optisch untersucht. Wenn die Farbe unverändert blieb, war das Teil nicht oxidiert. Wenn eine rötlich braune oder irgendeine Verfärbung erschien, war das Teil oxidiert.

Beispiel A

Dies ist ein Beispiel mit einem Kupferpulver, das mit ansprüchsgemäße beschichtet ist, und $MnB_2$. Anmerkung: nicht-oxidierte Oberfläche, sehr gute Lötbarkeit und Haftfestigkeit.

Beispiel B

Keine Beschichtung auf dem Kupferpulver, $MnB_2$. Anmerkung: schlechte Haftfestigkeit und oxidierte Oberfläche.

Beispiel C

Organische Beschichtung auf dem Kupferpulver, $MnB_2$. Anmerkung: schlechte Haftfestigkeit und oxidierte Oberfläche.

Beispiel D

Ansprüchsgemäße Beschichtung auf dem Kupferpulver, kein $MnB_2$.

Beispiele A bis D

Beispiele A bis D zeigen deutlich, daß beide - eine ansprüchsgemäße Beschichtung und $MnB_2$ - für alle drei Eigenschaften notwendig sind: Lötbarkeit, Haftfestigkeit und nicht-oxidierte Oberfläche.

Beispiel E

Ansprüchsgemäße Beschichtung auf dem Kupferpulver, B.
Anmerkung: schlechte Haftfestigkeit, oxidierte Oberfläche.

Beispiel F

Ansprüchsgemäße Beschichtung auf dem Kupferpulver, $MnO_2$.
Anmerkung: oxidierte Oberfläche.

Beispiel G

Ansprüchsgemäße Beschichtung auf dem Kupferpulver, $Ni_3B$.
Anmerkung: oxidierte Oberfläche.

Beispiele E bis G

Beispiele E bis G zeigen, daß nur $MnB_2$ eine nicht-oxidierte Oberfläche ergibt.

Beispiel H

Ansprüchsgemäße Beschichtung auf dem Kupferpulver, große Menge von $MnB_2$ : 2 %.
Anmerkung: schlechte Haftfestigkeit. Dieses Beispiel weist die obere Grenze für $MnB_2$ auf.

Beispiel I

Ansprüchsgemäße Beschichtung auf dem Kupferpulver, $MnB_2$, Ag.
Anmerkung: sehr gute Lötbarkeit, Haftfestigkeit und nicht-oxidierte Oberfläche.

Beispiel J

Ansprüchsgemäße Beschichtung auf dem Kupferpulver, $MnB_2$, Glasfritte.
Anmerkung: gute Lötbarkeit, Haftfestigkeit, nicht-oxidierte Oberfläche.

Beispiel K

Ansprüchsgemäße Beschichtung auf dem Kupferpulver, $MnB_2$, $PbO_2$.
Anmerkung: sehr gute Lötbarkeit, Haftfestigkeit, nicht-oxidierte Oberfläche.

Beispiele H bis K

Beispiele H bis K beweisen, daß andere Zusätze verwendet werden können.

Beispiel L

80 % Kupferpulver mit asprüchsgemäßer Beschichtung, 20 % unbeschichtetes Kupferpulver, $MnB_2$.
Anmerkung: sehr gute Haftfestigkeit, Lötbarkeit.
Beispiel L zeigt, daß sehr gute Eigenschaften selbst mit nur 80 % Kupferpulver mit ansprüchsgemäßer Beschichtung erreicht werden können.

## Tabelle

| Beispiel | A | B* | C* | D* | E* | F* | G* | H* | I | J | K | L |
|---|---|---|---|---|---|---|---|---|---|---|---|---|
| **Gewichts-%** | | | | | | | | | | | | |
| Kupfer mit Phosphat-Beschichtung | 81.52 | - | - | 80.99 | 79.50 | 79.00 | 79.00 | 78.50 | 80.94 | 79.00 | 63.15 | 65.15 |
| Keine Beschichtung | - | 81.52 | - | - | - | - | - | - | - | - | 15.79 | 16.28 |
| Organische Beschichtung | - | - | 81.52 | - | - | - | - | - | - | - | - | - |
| CuO | 6.19 | 6.19 | 6.19 | 6.15 | 7.00 | 7.00 | 7.00 | 7.00 | 6.15 | 7.00 | 7.76 | 6.00 |
| $MnB_2$ | 0.90 | 0.90 | 0.90 | - | - | - | - | 2.00 | 0.90 | 1.00 | 1.00 | 1.00 |
| Ag | - | - | - | - | - | - | - | - | 0.7 | - | - | - |
| Glas | - | - | - | - | - | - | - | - | - | 1.00 | - | - |
| $MnO_2$ | - | - | - | - | - | 1.0 | - | - | - | - | - | - |
| B | - | - | - | - | 0.50 | - | - | - | - | - | - | - |
| $Ni_3B$ | - | - | - | - | - | - | 1.00 | - | - | - | - | - |
| $PbO_2$ | - | - | - | - | - | - | - | - | - | - | 3.00 | - |
| Trägermittel | 11.39 | 11.39 | 11.39 | 12.86 | 13.00 | 13.00 | 13.00 | 12.50 | 11.31 | 12.00 | 9.30 | 11.57 |
| Lötbarkeit | sehr gut | - | - | gut | sehr gut | sehr gut | gut | schlecht | sehr gut | sehr gut | sehr gut | sehr gut |
| Haftfestigkeit (Anfänglich/gealtert) | 7.3/4 | 0 | 0 | 2.9/1.2 | 1.7/1.4 | 4.2/3.9 | 2.5/2.0 | 1.6/0 | 7.3/3.3 | 7.1/3.6 | 7.8/4.3 | 8.1/4.0 |
| Oberfläche | $U_n$ | $O_x$ | $O_x$ | $O_x$ | $O_x$ | $O_x$ | $O_x$ | $U_n$ | $U_n$ | $U_n$ | $U_n$ | $U_n$ |

\* Vergleichsbeispiele

$U_n$ : nicht-oxidiert

$O_x$ : oxidiert

## Patentansprüche

1. Nicht-oxidierender Kupfer-Dickfilmleiter, enthaltend Kupfer, welches metallisches Kupferpulver und Kupferoxid-Pulver umfaßt, eine Mangan-Bor-Verbindung, eine anorganische Phoshpor- oder Phosphorige Säure und ein organisches Trägermittel, worin der Gewichtsanteil für die Mangan-Bor-Verbindung 0,5 bis 1,5 Gewichts-%, bezogen auf das Gesamtgewicht des Leiters, und die Phosphat/Phosphit-

EP 0 327 816 B1

Menge 50 bis 300 ppm, bezogen auf das Gewicht des metallischen Kupferpulvers, betragen.

2. Kupfer-Dickfilmleiter nach Anspruch 1, dadurch gekennzeichnet, daß die Mangan-Bor-Verbindung aus der Gruppe, bestehend aus Manganborid und Manganborat, ausgewählt ist.

3. Kupfer-Dickfilmleiter nach Anspruch 1, dadurch gekennzeichnet, daß das Kupferoxid-Pulver aus der Gruppe, bestehend aus Kupfer(II)-oxid und Kupfer(I)-oxid, ausgewählt ist.

4. Kupfer-Dickfilmleiter nach Anspruch 3, dadurch gekennzeichnet, daß das metallische Kupfer mit einer monomolekularen Schicht einer anorganischen Phosphor- oder Phosphorigen Säure beschichtet ist.

5. Kupfer-Dickfilmleiter nach Anspruch 4, dadurch gekennzeichnet, daß wenigstens 70 % des gesamten metallischen Kupfers eine anorganische Phosphor- oder Phosphorigsäure-Beschichtung aufweisen.

6. Kupfer-Dickfilmleiter nach Anspruch 3, dadurch gekennzeichnet, daß 4 bis 10 Gewichts-% des gesamten Leitergewichts Kupferoxid sind.

7. Kupfer-Dickfilmleiter nach Anspruch 3, dadurch gekennzeichnet, daß 5 bis 8 Gewichts-% des gesamten Leitergewichts Kupferoxid sind.

8. Kupfer-Dickfilmleiter nach Anspruch 3, dadurch gekennzeichnet, daß das metallische Kupferpulver eine spezifische Oberfläche von 0,50 bis 1,20 m$^2$/g und eine Klopfdichte von 2,5 bis 4,2 g/m$^2$ besitzt.

9. Kupfer-Dickfilmleiter nach Anspruch 3, dadurch gekennzeichnet, daß das Kupferoxid eine spezifische Oberfläche von 2 bis 6 m$^2$/g besitzt.

10. Kupfer-Dickfilmleiter nach Anspruch 1, dadurch gekennzeichnet, daß die anorganische Phosphor- oder Phosphorige Säure aus der Gruppe, bestehend aus unterphosphoriger Säure, metaphosphoriger Säure, orthophosphoriger Säure, pyrophosphoriger Säure, Hypophosphorsäure, Metaphosphorsäure, Orthophosphorsäure, Difluorophosphorsäure, ausgewählt ist.

11. Kupfer-Dickfilmleiter nach Anspruch 1, dadurch gekennzeichnet, daß die Mangan-Bor-Verbindung eine spezifische Oberfläche von 0,5 bis 3,0 m$^2$ /g aufweist.

12. Kupfer-Dickfilmleiter nach Anspruch 1, dadurch gekennzeichnet, daß der Gewichtsanteil der Mangan-Bor-Verbindung 0,7 bis 1,2 Gewichts-%, bezogen auf das gesamte Leitergewicht, beträgt.

13. Kupfer-Dickfilmleiter nach Anspruch 1, dadurch gekennzeichnet, daß der Phosphat/Phosphit-G 70 bis 150 ppm, bezogen auf das Gewicht des metallischen Kupferpulvers, beträgt.

## Claims

1. A non-oxidising copper thick film conductor, containing copper, which comprises metallic copper powder and copper oxide powder, a manganese-boron compound, an inorganic phosphoric or phosphorous acid and an organic carrier agent, in which the proportion by weight for the manganese-boron compound amounts to 0.5 to 1.5% by weight in relation to the total weight of the conductor, and the phosphate/phosphite quantity amounts to 50 to 300 ppm, in relation to the weight of the metallic copper powder.

2. A copper thick film conductor according to Claim 1, characterised in that the manganese-boron compound is selected from the group consisting of manganese boride and manganese borate.

3. A copper thick film conductor according to Claim 1, characterised in that the copper oxide powder is selected from the group consisting of copper(II) oxide and copper(I) oxide.

4. A copper thick film conductor according to Claim 3, characterised in that the metallic copper is coated with a monomolecular layer of an inorganic phosphoric or phosphorous acid.

8

5. A copper thick film conductor according to Claim 4, characterised in that at least 70% of the total metallic copper has an inorganic phosphoric or phosphorous acid coating.

6. A copper thick film conductor according to Claim 3, characterised in that 4 to 10% by weight of the total conductor weight is copper oxide.

7. A copper thick film conductor according to Claim 3, characterised in that 5 to 8% by weight of the total conductor weight is copper oxide.

8. A copper thick film conductor according to Claim 3, characterised in that the metallic copper powder has a specific surface of 0.50 to 1.20 $m^2/g$ and a knocking density of 2.5 to 4.2 $g/m^2$.

9. A copper thick film conductor according to Claim 3, characterised in that the copper oxide has a specific surface of 2 to 6 $m^2/g$.

10. A copper thick film conductor according to Claim 1, characterised in that the inorganic phosphoric or phosphorous acid is selected from the group consisting of hypophosphorous acid, metaphosphorous acid, orthophosphorous acid, pyrophosphorous acid, hypophosphoric acid, metaphosphoric acid, orthophosphoric acid, difluorophosphoric acid.

11. A copper thick film conductor according to Claim 1, characterised in that the manganese-boron compound has a specific surface of 0.5 to 3.0 $m^2/g$.

12. A copper thick film conductor according to Claim 1, characterised in that the proportion by weight of the manganese-boron compound amounts to 0.7 to 1.2% by weight, in relation to the total conductor weight.

13. A copper thick film conductor according to Claim 1, characterised in that the phosphate/phosphite content amounts to 70 to 150 ppm, in relation to the weight of the metallic copper powder.

**Revendications**

1. Conducteur à couches épaisses en cuivre, non oxydable, contenant du cuivre qui comprend de la poudre de cuivre métallique et de la poudre d'oxyde de cuivre, un composé de manganèse-bore, un acide inorganique phosphorique ou phosphoreux et un véhicule organique, dans lequel le pourcentage en poids du composé de manganèse-bore, rapporté au poids total du conducteur, est compris entre 0,5 et 1,5% en poids et la quantité de phosphate/phosphite, rapportée au poids de la poudre de cuivre métallique, est comprise entre 50 et 300 ppm.

2. Conducteur à couches épaisses en cuivre selon la revendication 1, caractérisé en ce que le composé de manganèse-bore est sélectionné dans le groupe constitué par le borure de manganèse et le borate de manganèse.

3. Conducteur à couches épaisses en cuivre selon la revendication 1, caractérisé en ce que la poudre d'oxyde de cuivre est sélectionnée dans le groupe constitué par l'oxyde de cuivre (II) et l'oxyde de cuivre (I).

4. Conducteur à couches épaisses en cuivre selon la revendication 1, caractérisé en ce que le cuivre métallique est recouvert d'une couche monomoléculaire d'un acide inorganique phosphorique ou phosphoreux.

5. Conducteur à couches épaisses en cuivre selon la revendication 4, caractérisé en ce qu'au moins 70% du cuivre métallique total comporte un revêtement en acide inorganique phosphorique ou phosphoreux.

6. Conducteur à couches épaisses en cuivre selon la revendication 3, caractérisé en ce que 4 à 10% en poids du poids total du conducteur sont de l'oxyde de cuivre.

**7.** Conducteur à couches épaisses en cuivre selon la revendication 3, caractérisé en ce que 5 à 8% en poids du poids total du conducteur sont de l'oxyde de cuivre.

**8.** Conducteur à couches épaisses en cuivre selon la revendication 3, caractérisé en ce que la poudre de cuivre métallique possède une surface spécifique comprise entre 0,50 et 1,20 $m^2$/g et une masse volumique après tassement comprise entre 2,5 et 4,2 $g/m^2$.

**9.** Conducteur à couches épaisses en cuivre selon la revendication 3, caractérisé en ce que l'oxyde de cuivre possède une surface spécifique comprise entre 2 et 6 $m^2$/g.

**10.** Conducteur à couches épaisses en cuivre selon la revendication 1, caractérisé en ce que l'acide inorganique phosphorique ou phosphoreux est sélectionné dans le groupe constitué par l'acide hypophosphoreux, l'acide métaphosphoreux, l'acide orthophosphoreux, l'acide pyrophosphoreux, l'acide hyphosphorique, l'acide métaphosphorique, l'acide orthophosphorique, l'acide difluorophosphorique.

**11.** Conducteur à couches épaisses en cuivre selon la revendication 1, caractérisé en ce que le composé de manganèse-bore présente une surface spécifique comprise entre 0,5 et 3,0 $m^2$/g.

**12.** Conducteur à couches épaisses en cuivre selon la revendication 1, caractérisé en ce que le pourcentage en poids du composé de manganèse-bore, rapporté au poids total du conducteur, est compris entre 0,7 et 1,2% en poids.

**13.** Conducteur à couches épaisses en cuivre selon la revendication 1, caractérisé en ce que la teneur en phosphate/phosphite, rapportée au poids de la poudre de cuivre métallique, est comprise entre 70 et 150 ppm.